**Europäisches Patentamt**

**European Patent Office**

**Office européen des brevets**

(11) Veröffentlichungsnummer: **0 011 233**

**A1**

# (12) EUROPÄISCHE PATENTANMELDUNG

(21) Anmeldenummer: **79104370.6**

(22) Anmeldetag: **07.11.79**

(51) Int. Cl.³: **H 03 G 3/32**
**G 08 B 3/00**

(30) Priorität: **17.11.78 DE 2849961**

(43) Veröffentlichungstag der Anmeldung:
**28.05.80 Patentblatt 80/11**

(84) Benannte Vertragsstaaten:
**FR GB IT**

(71) Anmelder: **SIEMENS AKTIENGESELLSCHAFT Berlin und München**
**Postfach 22 02 61**
**D-8000 München 22(DE)**

(72) Erfinder: **Müller, Rüdiger, Dr.**
**Putzbrunnerstrasse 131**
**D-8000 München 83(DE)**

(72) Erfinder: **Rabl, Helmut, Dipl.-Ing.**
**Ortlindestrasse 6**
**D-8000 München 81(DE)**

(54) **Elektroakustischer Signalgeber mit automatischer Lautstärkeanpassung an den Umgebungsgeräuschpegel.**

(57) Bei einem elektroakustischen Signalgeber mit Tonfrequenzgenerator (4,5) und Lautsprecher (1) wird zur automatischen Lautstärkeanpassung an den Umgebungsgeräuschpegel vorgeschlagen, während der Ruhepausen den Lautsprecher (1) als Mikrofon zu verwenden, das zeitverzögert während der Betriebsphase ein Steuersignal für die Amplitude des vom Generator (5) erzeugten Tonfrequenz-Signals liefert.

FIG 1

SIEMENS AKTIENGESELLSCHAFT          Unser Zeichen
Berlin und München                  VPA 73 P 1 2 0 6 EUR

Elektroakustischer Signalgeber mit automatischer Lautstärkeanpassung an den Umgebungsgeräuschpegel.

Die Erfindung betrifft einen elektroakustischen Signalgeber mit automatischer Lautstärkeanpassung an
den Umgebungsgeräuschpegel, enthaltend einen Generator für eine Tonfrequenzspannung und einen Lautsprecher.

Elektroakustische Signalgeber werden z.B. als
Warn- oder Aufforderungseinrichtung verwendet. Das
elektroakustische Signal kann eine beliebige gewünschte
Form haben. Es kann dies eine Tonfolge sein oder ein
Zusammenklang mehrerer Töne. Auch kann der zeitliche
Ablauf eines oder mehrerer Töne in der Frequenz und/
oder der Amplitude variieren. Das Signal wird zunächst
als elektrische Signalspannung erzeugt und über einen

RH 1 Ode /15.11.78

elektroakustischen Wandler (Lautsprecher) hörbar gemacht.

Beispielsweise kann der elektroakustische Signalgeber als elektronischer Gong verwendet werden. Dabei ist ein Gong definiert als ein schwingungsfähiger Körper, der nach mechanischem Anschlagen einen hörbaren Ton abgibt. Die Lautstärke des Tons nimmt infolge der Dämpfung exponentiell ab. Das menschliche Ohr empfindet den Ton eines Gongs im allgemeinen angenehmer als einen während einer längeren Zeitperiode gleichbleibenden Ton, wie ihn z.B. eine Sirene abgibt. Ein elektroakustischer Signalgeber kann einen solchen mechanischen Gong elektronisch nachbilden.

Wenn ein elektroakustischer Signalgeber in einer Umgebung betrieben wird, in der ein sich in weiten Grenzen ändernder Geräuschpegel auftreten kann (z.B. beim Kraftfahrzeug), ist zu fordern, daß sich seine Lautstärke dem beim Betätigungszeitpunkt zufällig vorhandenen Geräuschpegel automatisch anpaßt. Nur dann ist gewährleistet, daß das Signal bei geringem Geräuschpegel nicht störend empfunden, aber bei hohem Geräuschpegel noch sicher wahrgenommen wird.

Nach der der vorliegenden Erfindung zugrundeliegenden Aufgabe soll ein solcher elektroakustischer Signalgeber mit einer automatischen Lautstärkeanpassung an den Umgebungsgeräuschpegel versehen werden.

Zur Lösung dieser Aufgabe wird bei einem elektro-akustischen Signalgeber der eingangs genannten Art erfindungsgemäß vorgeschlagen,

a) der Lautsprecher wird zeitlich vor dem Signal als Mikrofon für die Umgebungsgeräusche verwendet;

b) er liegt am Eingang eines Mikrofonverstärkers;

c) dem Mikrofonverstärker ist ein Spitzenspannungs-gleichrichter nachgeschaltet mit einer Zeitkon-stante in der Größenordnung von Sekunden;

d) der Gleichrichterausgang liegt an einem Steuereingang für den Generator;

e) das Gleichrichterausgangssignal steuert die Amplitude der Tonfrequenzspannung des Generators.

Dadurch, daß zur Geräuschpegelerfassung der ohnehin vorhandene Lautsprecher verwendet wird, ist der technische Aufwand für die automatische Anpassung recht gering. Zeitlich vor dem Signal bzw. während der Ruhepausen zwischen den Signalen steht ständig eine Spannung zur Verfügung, die ein Maß für den Umgebungsgeräuschpegel ist und zur Steuerung des Tonfrequenzsignals verwendet werden kann.

Vorteilhaft für die entsprechende Steuerung ist folgende Ausführung:

f) der Generator für die Tonfrequenzspannung ent-hält einen Tonfrequenzerzeuger, einen nachge-schalteten Generatorverstärker und einen Erzeuger einer Steuerspannung;

g) dem Generatorverstärker werden diese Steuerspannung und die Gleichrichterausgangsspannung zur Steuerung der Amplitude der Tonfrequenzspannung zugeführt.

Mit dem Betätigen einer Auslöseeinrichtung (z.B. Taste) wird die Funktion des Lautsprechers als Mikrofon beendet. Das den Umgebungsgeräuschpegel repräsentierende Signal steht mit Zeitverzögerung noch zur Verfügung und steuert die Amplitude des Tonfrequenzsignals.

Dieses Beenden der Mikrofonrolle des Lautsprechers für die Zeit der Signalabgabe geschieht nach einer Ausgestaltung eines erfindungsgemäßen elektroakustischen Signalgebers mit einem Umschalter, der den Lautsprecher beim Auslösen des Signals vom Eingang des Mikrofonverstärkers zum Ausgang des Generatorverstärkers schaltet und nach Beenden des Signals wieder zurückschaltet.

Eine weitere vorteilhafte Ausgestaltung mit einer einfacheren und deshalb billigeren Schaltversion sieht einen Schalter vor, der nach Auslösen des Signals für dessen Dauer den Gleichrichter vom Mikrofonverstärker abtrennt.

Anhand zweier in den Figuren der Zeichnung schematisch dargestellten Ausführungsbeispiele soll die Erfindung näher erläutert werden. Dabei stellen dar
Fig. 1 das Blockschaltbild eines erfindungsgemäßen elektroakustischen Signalgebers als elektronischer Gong in der Ausführung mit Umschalter,

Fig. 2 das Blockschaltbild eines elektronischen Gongs in der Ausführung mit einem einfachen Schalter für das Abschalten der Mikrofonfunktion des Lautsprechers,

Fig. 3 den zeitlichen Verlauf der wesentlichen Signale.

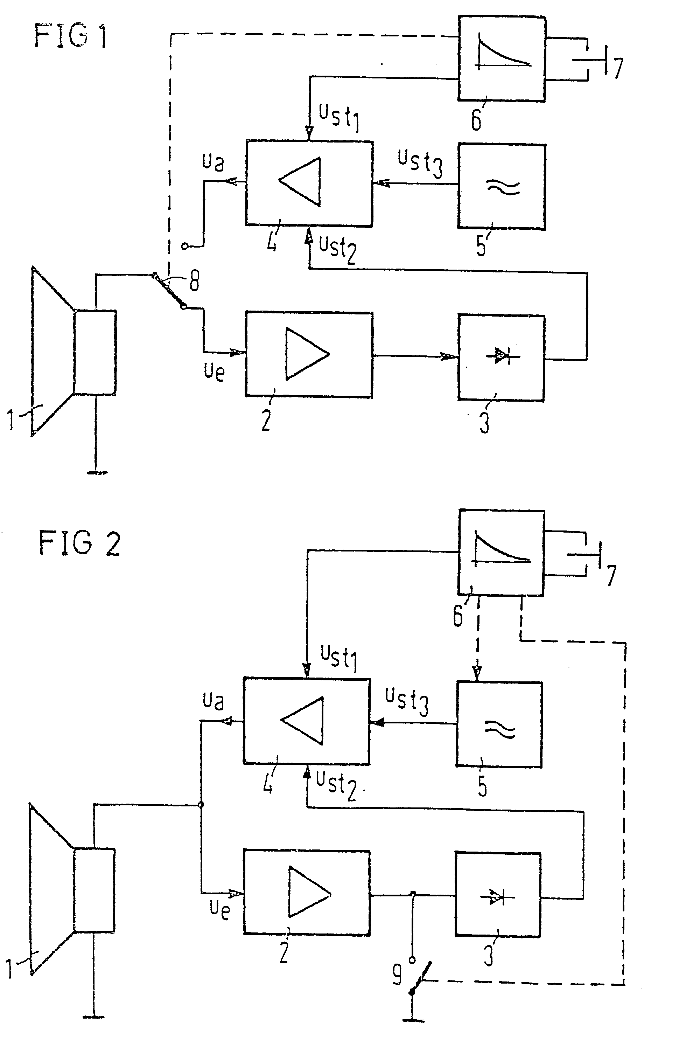

In Fig. 1 ist mit 1 ein Lautsprecher bezeichnet, der auch als Mikrofon verwendet werden kann. Er ist mit dem Mittenkontakt eines Umschalters 8 verbunden. Der eine von zwei Umschaltkontakten des Umschalters 8 liegt am Eingang eines Mikrofonverstärkers 2, so genannt, weil er das vom Lautsprecher 1 als Mikrofon gelieferte Signal verstärkt. Er ist ein Tonfrequenzverstärker mit hohem Verstärkungsgrad, etwa 60 bis 90 dB. Das zu verstärkende Signal ist mit $u_e$ bezeichnet. Der andere Umschaltkontakt liegt am Ausgang eines Generatorverstärkers 4 mit dem Ausgangssignal $u_a$. Dieser ist ebenfalls ein Tonfrequenzverstärker, aber mit steuerbarem Verstärkungsgrad. Zu diesem Zweck hat er zwei Steuereingänge. Der Ausgang des Mikrofonverstärkers 2 führt über einen Gleichrichter 3 mit Spitzenspannungsgleichrichtung zu dem einen Steuereingang des Generatorverstärkers 4 und liefert dort das Steuersignal $u_{st2}$. Ein Zeitglied als Erzeuger für ein exponentiell abnehmendes Steuersignal $u_{st1}$ ist mit 6 bezeichnet und führt zu dem anderen Steuereingang des Generatorverstärkers 4. Gespeist wird der Generatorverstärker 4 vom Signal $u_{st3}$ eines Tonfrequenzerzeugers 5. Am Eingang des Zeitglieds 6 liegt eine Betätigungstaste 7. Außerdem ist ein Ausgang des Zeitglieds 6 mit einem Steuereingang des Umschalters 8 verbunden.

Im Ruhezustand dient der Lautsprecher 1 als Mikrofon und ist über den Umschalter 8 in dessen Ruhestellung mit dem Mikrofonverstärker 2 verbunden. Der Tonfrequenzerzeuger 6 liefert das Tonfrequenzsignal $u_{st3}$, der Gleichrichter 3 das Steuersignal $u_{st2}$, das der Stärke des Umgebungsgeräuschpegels entspricht. Zum Auslösen des Gongs wird die Betätigungstaste 7 gedrückt. Das Zeitglied 6 schaltet daraufhin den Umschalter 8 in Arbeitsstellung, d.h. trennt den Mikrofonverstärker 2 vom Lautsprecher 1 und verbindet den Ausgang des Generatorverstärkers 6 mit dem Lautsprecher 1. Gleichzeitig erzeugt es das exponentiell abklingende Steuersignal $u_{st1}$ und liefert es an den Generatorverstärker 4. Dieser gibt nun das Tonfrequenzsignal $u_a$ an den Lautsprecher 1, das aus dem vom Tonfrequenzerzeuger 5 gelieferten Signal $u_{st3}$ besteht und dessen Amplitude exponentiell abklingt mit einem Anfangswert, der vom Steuersignal $u_{st2}$ bestimmt wird.

Wenn das Steuersignal $u_{st1}$ einen gewissen Wert unterschritten hat, d.h., das vom Lautsprecher 1 erzeugte akustische Signal bereits so leise geworden ist, daß es praktisch nicht mehr hörbar ist, wird der Umschalter 8 wieder in Ruhestellung umgeschaltet.

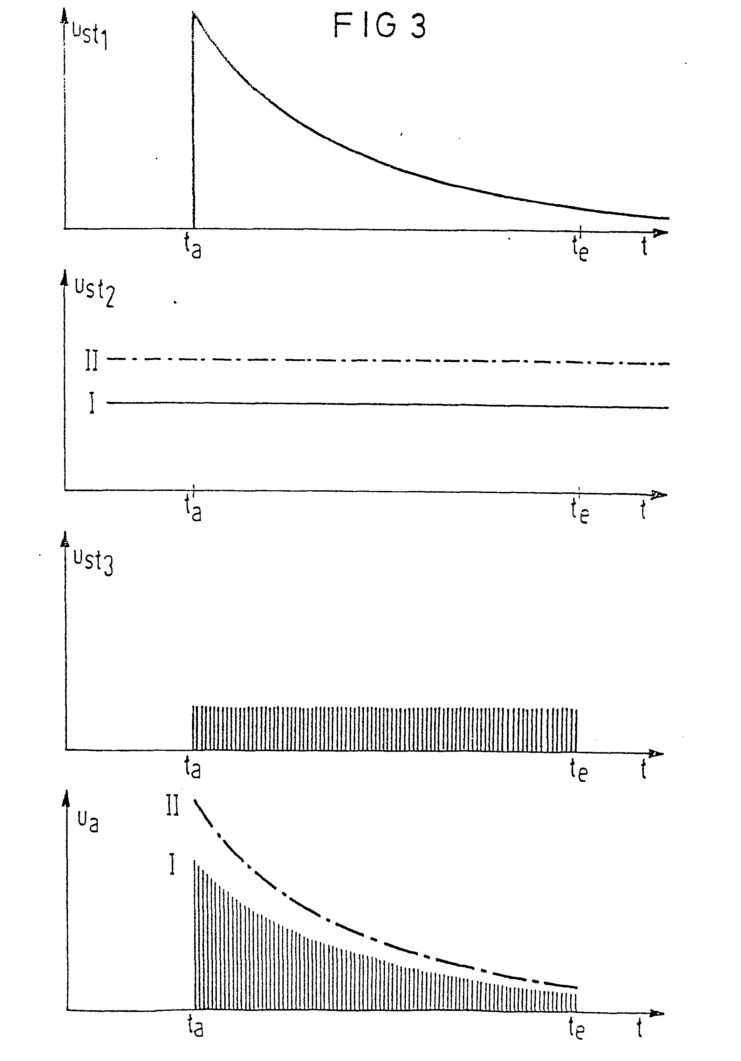

Aus der Fig. 3 ist der zeitliche Verlauf der drei Steuersignalspannungen $u_{st1}$, $u_{st2}$, $u_{st3}$ sowie des Ausgangssignals $u_a$ des Generatorverstärkers 4 zu ersehen. Das Steuersignal $u_{st1}$ verläuft exponentiell abklingend, das Steuersignal $u_{st2}$ konstant. Mit I ist der Verlauf

des Steuersignals $u_{st2}$ und des Signals $u_a$ bei geringem Pegel der Umgebungsgeräusche, und mit II der bei hohem Pegel bezeichnet. Der Auslösezeitpunkt des Gongs ist $t_a$, der der Beendigung $t_e$. Dazwischen liegt beispielsweise eine Zeit von einer Sekunde. Der Tonfrequenzerzeuger 5 gibt eine amplituden- und frequenzkonstante Wechselspannung $u_{st3}$ ab, die je nach dem gewünschten Oberwellengehalt, d.h. dann Ton- bzw. Klangfarbe des Gongtons, beispielsweise sinusförmig, rechteckförmig oder sägezahnförmig verlaufen kann. Das Ausgangssignal $u_a$ des Generatorverstärkers 4 besteht dann aus dem Tonfrequenzsignal $u_{st3}$, dessen Amplitude vom Anfangswert I oder II (je nach Steuersignal $u_{st2}$) exponentiell abklingt.

Die Ausführung nach Fig. 2 entspricht im wesentlichen der nach Fig. 1. Unterschiedlich ist, daß der Umschalter 8 fehlt. Der Lautsprecher 1 ist fest mit dem Ausgang des Generatorverstärkers 4 und mit dem Eingang des Mikrofonverstärkers 2 verbunden. Statt dessen liegt zwischen dem Mikrofonverstärker 2 und dem Gleichrichter 3 ein Schalter 9, mit dem die Verbindung beider getrennt werden kann. Betätigt wird der Schalter 9 wieder vom Zeitglied 6. Ein weiterer Unterschied besteht darin, daß der Tonfrequenzerzeuger 5 nur für die Zeit der Gongbetätigung arbeitet und dementsprechend vom Zeitglied 6 gesteuert wird. Das ist vorteilhaft, weil z.B. eventuelle Störkopplungen im Ruhezustand des Gongs vermieden werden.

Während der Gongbetätigung ist der Mikrofonverstärker 2 in der Version nach Fig. 2 sicher übersteuert. Eine nachfolgende Erhöhung der Steuerspannung $u_{st2}$ wird durch Abtrennen des Gleichrichters 3 vom Mikrofonverstärker 2 über den Schalter 9 verhindert. Vorteilhaft ist die einfache Schalterausführung. Es kann ein Relais mit Metallkontakten oder auch ein Halbleiterschalter sein.

4 Patentansprüche

3 Figuren

0011233

78 P 1 2 0 6 EUR

<u>Patentansprüche</u>

1. Elektroakustischer Signalgeber mit automatischer Lautstärkeanpassung an den Umgebungsgeräuschpegel, enthaltend einen Generator für eine Tonfrequenzspannung und einen Lautsprecher, g e k e n n - z e i c h n e t  d u r c h  folgende Merkmale:

a) der Lautsprecher (1) wird zeitlich vor dem Signal als Mikrofon für die Umgebungsgeräusche verwendet;

b) er liegt am Eingang eines Mikrofonverstärkers (2);

c) dem Mikrofonverstärker (2) ist ein Spitzenspannungsgleichrichter (3) nachgeschaltet mit einer Zeitkonstante in der Größenordnung von Sekunden;

d) der Gleichrichterausgang liegt an einem Steuereingang für den Generator (4,5,6);

e) das Gleichrichterausgangssignal steuert die Amplitude der Tonfrequenzspannung des Generators (4,5,6).

2. Elektroakustischer Signalgeber nach Anspruch 1, g e k e n n z e i c h n e t  d u r c h  folgende Merkmale:

f) der Generator (4,5,6) für die Tonfrequenzspannung enthält einen Tonfrequenzerzeuger (5), einen nachgeschalteten Generatorverstärker (4) und einen Erzeuger (6) einer Steuerspannung;

g) dem Generatorverstärker (4) werden diese Steuerspannung und die Gleichrichterausgangsspannung zur Steuerung der Amplitude der Tonfrequenzspannung zugeführt.

3. Elektroakustischer Signalgeber nach Anspruch 2, g e k e n n z e i c h n e t   d u r c h einen Umschalter (8), der den Lautsprecher (1) beim Auslösen des Signals vom Eingang des Mikrofonverstärkers (2) zum Ausgang des Generatorverstärkers (4) schaltet und nach Beenden des Signals wieder zurückschaltet.

4. Elektroakustischer Signalgeber nach Anspruch 2, g e k e n n z e i c h n e t   d u r c h   einen Schalter (9), der nach Auslösen des Signals für dessen Dauer den Gleichrichter (3) vom Mikrofon- verstärker (2) abtrennt.

FIG 1

FIG 2

FIG 3

**Europäisches Patentamt**

**EUROPÄISCHER RECHERCHENBERICHT**

Nummer der Anmeldung

0011233

EP 79 10 4370

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | <u>US - A - 3 410 958</u> (COHEN)<br><br>× Figuren 2-4; Spalte 6, Zeile 1 bis Spalte 10, Zeile 19 ×<br><br>-- | 1,2 |
| | <u>US - A - 3 135 836</u> (SCHWARTZ et al.)<br><br>× Figuren 2-6; Spalte 9, Zeilen 22-53; Spalte 3, Zeile 42 bis Spalte 7, Zeile 31 ×<br><br>-- | 1-3 |
| | <u>DE - B - 1 145 374</u> (NSM APPARATE-BAU)<br><br>× Figuren 3,5,7; Ansprüche 1-5 ×<br><br>-- | 1-3 |
| | <u>DE - A - 2 414 143</u> (TELEVISION RESEARCH)<br><br>× Einzige Figur; Seite 3, letzte Zeile bis Seite 8, Zeile 11 ×<br><br>-- | 1,2 |
| | <u>DE - C - 939 880</u> (SIEMENS & HALSKE)<br><br>× Figur 2; Seite 2, Zeilen 94-112 ×<br><br>-- | 1,2 |
| P | <u>DE - A - 2 756 943</u> (FUSBAN)<br><br>× Figur 4; Seite 5, Zeilen 4-17 ×<br><br>---- | 1 |

**KLASSIFIKATION DER ANMELDUNG (Int.Cl. 3)**

H 03 G 3/32
G 08 B 3/00

**RECHERCHIERTE SACHGEBIETE (Int. Cl. 3)**

H 03 G 3/32
3/24

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 20-02-1980 | GYSEN |

EPA form 1503.1 06.78